# EUROPEAN PATENT APPLICATION

(11) **EP 4 550 991 A1**
(43) Date of publication of application: **07.05.2025**
(21) Application number: 24197728.9
(22) Date of filing: 30.08.2024
(51) Int. Cl.: H10K 59/80, H10K 59/35

(54) **DISPLAY PANEL, DISPLAY MODULE AND DISPLAY DEVICE**

(30) Priority: 31.10.2023 CN 202311434146
(71) Applicant: Kunshan New Flat Panel Display Technology Center Co., Ltd., Kunshan, Jiangsu 215300 (CN)
(72) Inventor: LI, Tiantian, Kunshan 215300 (CN); SONG, Won Jun, Kunshan 215300 (CN); HA, Mihwa, Kunshan 215300 (CN); GAO, Yu, Kunshan 215300 (CN); MA, Chufang, Kunshan 215300 (CN)
(74) Representative: Kraus & Lederer PartGmbB

(57) **Abstract**

The present application relates to a display panel, a display module and a display device. The display panel comprises a substrate (10), a light emitting device layer (20) disposed on one side of the substrate (10), a light extraction layer assembly (30) disposed on the side of the light emitting device layer (20) facing away from the substrate (10) and an encapsulation structure (40) arranged in a stacked configuration wherein the light extraction layer assembly (30) comprises at least two light extraction layers arranged in a stacked configuration, and the at least two light extraction layers comprise a primary extraction layer (31) and at least one secondary extraction layer (32) disposed on one side or two opposite sides of the primary extraction layer (31), and wherein the primary extraction layer (31) has a refractive index greater than that of the secondary extraction layer (32). The display panel provided by the present application is designed with a light extraction layer assembly and an encapsulation structure above the light emitting device layer, and the light extraction film assembly layer is designed as a multilayer structure. By coordinating the refractive indices of at least two light extraction layers, the improvement of the light extraction effect and efficiency is achieved.

## Description

### TECHNICAL FIELD

The present application relates to the technical field of display, and particularly to a display panel, a display module and a display device.

### BACKGROUND

Organic Light Emitting Diode (OLED) display has the advantages of low cost, wide viewing angle, low driving voltage, fast response speed, rich light emitting colors, simple preparation process, and large-area flexible display, and the like, which is considered as one of the most promising display technologies. However, the display technology is required to be improved.

### SUMMARY

Embodiments of the present application provide a display panel, a display module and a display device.

In a first aspect, embodiments of the present application provide a display panel comprising: a substrate; a light emitting device layer disposed on one side of the substrate; a light extraction layer assembly disposed on the side of the light emitting device layer facing away from the substrate, wherein the light extraction layer assembly comprises at least two light extraction layers arranged in a stacked configuration, and the at least two light extraction layers comprise a primary extraction layer and at least one secondary extraction layer disposed on one side or two opposite sides of the primary extraction layer, and wherein the primary extraction layer has a refractive index greater than that of the secondary extraction layer; and an encapsulation structure disposed on the side of the light extraction layer assembly facing away from the substrate.

According to an embodiment of the first aspect of the present application, the secondary extraction layer comprises at least a first secondary extraction layer, and the first secondary extraction layer is disposed on the side of the primary extraction layer facing the substrate; the encapsulation structure has a refractive index less than the primary extraction layer;
Optionally, the encapsulation structure is disposed on the surface of the light extraction layer assembly;
Optionally, the primary extraction layer has a refractive index n₂ in a range of 1.7-2.6; and/or, the refractive index of the encapsulation structure is 1 .4-2.0;
Optionally, the first secondary extraction layer has a refractive index n1 in a range of 1.2-1 .6;
Optionally, a difference in refractive index Δn1 between any two of the at least two light extraction layers is greater than 0.5 and less than 1.4;
Optionally, the primary extraction layer has a thickness greater than the first secondary extraction layer;
Optionally, the first secondary extraction layer has a thickness d₁ greater than 5 nm and less than 40nm, and the primary extraction layer has a thickness d₂ greater than 20 nm and less than 70nm;
Optionally, a total thickness D₁=d₁+d₂ of the light extraction layer assembly is greater than 50nm and less than 110nm.

According to an embodiment of the first aspect of this application, the encapsulation structure includes at least two encapsulation layers arranged in a stacked configuration, the at least two encapsulation layers include a primary encapsulation layer and at least one secondary encapsulation layer, and the at least one secondary encapsulation layer is disposed on one side or two opposite sides of the primary encapsulation layer; and the primary encapsulation layer has a refractive index less than the secondary encapsulation layer;
Optionally, the at least one secondary encapsulation layer comprises at least one first secondary encapsulation layer and at least one second secondary encapsulation layer, and the at least one first secondary encapsulation layer and the at least one second secondary encapsulation layer are disposed on two opposite sides of the primary encapsulation layer; and the first secondary encapsulation layer has a refractive index n₄ in a range of 1.4-2.0, the primary encapsulation layer has a refractive index of n₅ in a range of 1.4-1.6, and the second secondary encapsulation layer has a refractive index n₆ in a range of 1.4-2.0;
Optionally, the at least one secondary encapsulation layer is disposed on two opposite sides of the primary encapsulation layer, and the secondary encapsulation layers on two opposite sides of the primary encapsulation layer have the same refractive index;
Optionally, a plurality of secondary encapsulation layers are disposed on one side of the primary encapsulation layer, and the plurality of secondary encapsulation layers have refractive indices that increase in a direction from the primary encapsulation layer to the secondary encapsulation layer.

According to an embodiment of the first aspect of this application, when a difference in refractive index Δn2 (n₄-n₅ or n₆-n₅) between any two of the at least two encapsulation layers is less than 0.2, a difference in refractive index Δn3 (n₂-n₄) between the primary extraction layer and the first secondary encapsulation layer is greater than 0.6 and less than 1.2; optionally, n₂ is in a range of 2.2-2.6.

According to an embodiment of the first aspect of this application, the first secondary extraction layer has a refractive index less than the first secondary encapsulation layer;

Optionally, n₁ is in a range of 1.4-1.6, n₂ is in a range of 2.0 -2.4, n₄ is in a range of 1.7-2.0, n₅ is in a range of 1 .4-1.6, n₆ is in a range of 1.7-2.0, and a difference in refractive index Δn4 (n₂-n₄) between the primary extraction layer and the first secondary encapsulation layer is greater than or equal to 0 and less than 0.5.

According to an embodiment of the first aspect of this application, the secondary extraction layer comprises at least one first secondary extraction layer, the at least one first secondary extraction layer disposed on the side of the primary extraction layer facing the substrate; the secondary extraction layer further comprises at least one second secondary extraction layer, the at least one second secondary extraction layer disposed on the side of the primary extraction layer facing away from the substrate; the second secondary extraction layer has a refractive index less than the encapsulation structure;
Optionally, the first secondary extraction layer has a refractive index n₁ in a range of 1.2-1.6; the primary extraction layer has a refractive index n₂ in a range of 1.7-2.6; the second secondary extraction layer has a refractive index n₃ in a range of 1.2-1.6.

According to an embodiment of the first aspect of this application, the encapsulation structure comprises at least two encapsulation layers arranged in a stacked configuration, the at least two encapsulation layers comprise a primary encapsulation layer and at least one secondary encapsulation layer, the at least one secondary encapsulation layer comprises at least one first secondary encapsulation layer and at least one second secondary encapsulation layer, the at least one first secondary encapsulation layer and the at least one second secondary encapsulation layer are disposed on two opposite sides of the primary encapsulation layer; the primary encapsulation layer has a refractive index less than the secondary encapsulation layer; and the second secondary extraction layer has a refractive index less than the first secondary encapsulation layer;
Optionally, the first secondary encapsulation layer has a refractive index n₄ in a range of 1.4-2.0, the primary encapsulation layer has a refractive index n₅ in a range of 1.4-1.6, the second secondary encapsulation layer has a refractive index n₆ in a range of 1.4-2.0;
Optionally, the first secondary extraction layer has a thickness d₁ greater than 0 and less than 40nm, the primary extraction layer has a thickness d₂ greater than 30nm and less than 70nm, and the second secondary extraction layer has a thickness d₃ greater than 20nm and less than 50nm;
Optionally, a total thickness D₂=d₁+d₂+d₃ of the light extraction layer assembly layer is greater than 70nm and less than 160nm;
Optionally, a difference in refractive index Δn5(n₂-n₁ or n₂-n₃)between any two of the at least two light extraction layers is greater than 0.5 and less than 1.4;
Optionally, n₃ is in a range of 1.4-1.6, n₄ is in a range of 1.8-2.0, n₅ is in a range of 1.4-1.6, and n₆ is in a range of 1 .8-2.0;
Optionally, when a difference in refractive index Δn6(n₄-n₅ or n₆-n₅) between any two of the at least two encapsulation layers is less than 0.4, a difference in refractive index Δn7(n₄-n₃) between the first secondary encapsulation layer and the second secondary extraction layer is greater than or equal to 0 and less than 0.5.

According to an embodiment of the first aspect of the present application, the light emitting device layer comprises a plurality of light emitting units, each of the light emitting units having a orthographic projection on the substrate located within orthographic projection of the light extraction layer assembly on the substrate; or
the light emitting device layer comprises a light emitting unit of a first color and a light emitting unit of a second color, the light emitting unit of the first color having a orthographic projection on the substrate located within the orthographic projection of the light extraction layer assembly on the substrate, and the light emitting unit of the second color has a orthographic projection on the substrate located outside the orthographic projection of the light extraction layer assembly on the substrate.

Optionally, the first color is blue and the second color is red or green.

In a second aspect, embodiments of the present application provide a display module comprising the display panel as described above.

In a third aspect, embodiments of the present application provide a display device comprising the display panel or the display module as described above.

Compared with the prior art, the present application has at least the following technical effects:
The embodiments of the present application provide a display panel designed with a light extraction layer assembly and an encapsulation layer over the light emitting device layer in which the light extraction layer assembly is designed as a multi-layer structure. By coordinating the refractive indices of at least two light extraction layers, the improvement of light emission effect and efficiency is achieved.

### DESCRIPTION OF THE DRAWINGS

Features, advantages and technical effects of exemplary embodiments of the present application will be described below with reference to the accompanying drawings.
FIG. 1 is a schematic diagram of the structure of a display panel according to an embodiment of the present application;
FIG. 2 is a schematic diagram of the structure of another display panel according to an embodiment of the present application;
FIG. 3 is a schematic diagram of the structure of another display panel according to an embodiment of the present application;
FIG. 4 is a schematic diagram of the structure of another display panel according to an embodiment of the present application;
FIG. 5 is a schematic diagram of the structure of another display panel according to an embodiment of the present application.

The accompanying drawings are labelled:
In the accompanying drawings, the same components use the same accompanying markings. The accompanying drawings are not drawn to actual scale.
10, substrate; 20, a light emitting device layer; 20a, a light emitting unit of a first color; 20b, a light emitting unit of a second color; 21, a second electrode layer; 22, a light emitting structure; 23, a first electrode layer; 24; a pixel definition layer;
30, a light extraction layer assembly; 31, a primary extraction layer; 32, a secondary extraction layer; 321, a first secondary extraction layer; 322, a second secondary extraction layer;
40, an encapsulation structure; 41, a primary encapsulation layer; 42, a secondary encapsulation layer; 421, a first secondary encapsulation layer; 422, a second secondary encapsulation layer.

### DETAILED DESCRIPTION

Features and exemplary embodiments of various aspects of the present application will be described in details below. In the following detailed description, a number of specific details are presented in order to provide a full understanding of the present application. However, it will be apparent to those skilled in the art that the present application can be implemented without some of these specific details. The following description of embodiments is provided solely for the purpose of providing a better understanding of the present application by illustrating examples of the application. In the accompanying drawings and the following description, at least some of the well-known structures and techniques are not illustrated in order to avoid unnecessary ambiguity to the present application; and, the dimensions of some of the structures may be exaggerated for clarity. Furthermore, the features, structures or characteristics described below may be combined in one or more embodiments in any suitable manner.

The words of orientation appearing in the following description are in the directions shown in the drawings and are not intended to limit the specific structure of the array substrate and display panel of the present application. In the description of the present application, it is to be noted that, unless otherwise expressly provided and limited, the terms 'mounting' and 'connecting' are to be broadly construed, e.g., they may be fixedly connected, removably connected, or integrally connected; they may be directly connected, or indirectly connected. To a person of ordinary skill in the art, the specific meanings of the above terms in the present application may be understood on a case-by-case basis.

Due to the mismatch of the refractive indices of the film layers in the display panel and the energy loss at the interface of the electrode and the organic material, there is a problem of low light extraction efficiency of the display panel.

In view of this, embodiments of the present application provide a display panel, and a display device capable of improving the light extraction efficiency. In order to better understand the present application, each embodiment of the display panel and the display device will be described below in conjunction with the accompanying drawings.

The following first describes the display panel provided by the embodiments of the present application, and the display panel provided by the embodiments of the present application may be an OLED display panel.

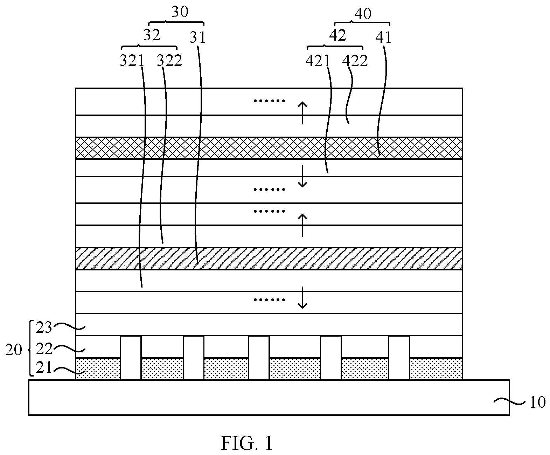

In a first aspect, the embodiments of the present application provide a display panel, as shown in FIG.1 to FIG. 3, comprising: a substrate 10; a light emitting device layer 20 provided on one side of the substrate 10; a light extraction layer assembly 30, disposed on the side of the light emitting device layer 20 facing away from the substrate 10, wherein the light extraction layer assembly 30 comprises at least two light extraction layers arranged in a stacked configuration, the at least two light extraction layers comprise a primary extraction layer 31 and at least one secondary extraction layer, the secondary extraction layer is disposed on one side or two opposite sides of the primary extraction layer 31, and wherein the primary extraction layer 31 has a refractive index greater than the secondary extraction layer; and an encapsulation structure, disposed on the side of the light extraction layer assembly facing away from the substrate.

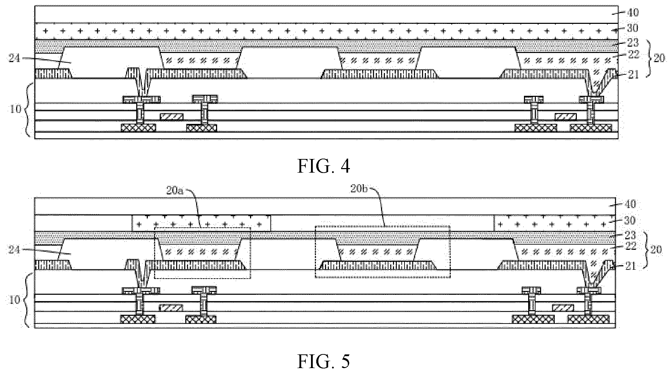

In some embodiments, referring to FIGS. 4 and 5, the substrate 10 may be a substrate 10 having a certain circuit structure for driving the light emitting device layer 20 disposed thereon for light emitting display. Optionally, the substrate 10 may include a substrate and an array substrate, and the array substrate may include a driving circuitry. For example, the array substrate may include a first conductive layer, a second conductive layer, and a third conductive layer disposed on one side of the substrate and in a stacked configuration. An insulating layer is provided between adjacent conductive layers. Exemplarily, a pixel driving circuit disposed in the array substrate comprises a transistor and a storage capacitor. The transistor comprises a semiconductor, a gate, a source, and a drain. The storage capacitor comprises a first plate and a second plate. As an example, the gate and the first plate may be located in the first conductive layer, the second plate may be located in a second conductive layer, and the source and drain may be located in a third conductive layer. A display panel further comprises a pixel defining layer 24, the pixel defining layer 24 being provided on the substrate and comprising a pixel defining portion and a pixel opening, and a light emitting structure 22 may be provided within the pixel opening to realize a light emitting display of the display panel. The substrate 10 may provide cushioning, protection, or support for the display panel, and the substrate 10 may be a flexible substrate 10, the material of which may, for example, comprises one or more of polyimide (PI), Polyethylene naphthalate (PEN), or polyethylene terephthalate (PET). The substrate 10 may also be a rigid substrate 10, for example, it may be a glass substrate 10.

The light emitting device layer 20 is disposed on one side of the substrate 10, and the light emitting device layer 20 is driven by an electrical signal to emit light for display, and the emitted light can pass through the light extraction layer assembly 30 and the encapsulation layer 40.

The light emitting device layer 20 may include a plurality of light emitting units distributed in an array; each light emitting unit may include a second electrode layer 21, a light emitting structure 22, and a first electrode layer 23 disposed sequentially from bottom to top, wherein the second electrode layer 21 is disposed close to the substrate 10 relative to the first electrode layer 23. In some embodiments, the light emitting structure 22 has a refractive index of 1.8 to 2.1. That is, refractive index = 1.8 to 2.1. Exemplarily, the light emitting structure 22 has a refractive index of 1.8, 1.9, 2.0, or 2.1. It is to be noted that, unless otherwise stated, the refractive index as described herein refers to the refractive index of the material for light with a wavelength of 460 nm.

Optionally, the second electrode layer 21 may be an anode, the light emitting structure 22 may be a layer structure formed of organic light emitting material, and the first electrode layer 23 may be a cathode. The second electrode layer 21 may be a structure of a three-layer superposition of a transparent conductive layer, a reflective conductive layer, and a transparent conductive layer, which has an all-reflective characteristic. The transparent conductive layer may be selected from any one or more of indium tin oxide (ITO), indium zinc oxide (IZO), and aluminium zinc oxide (AZO). The reflective conductive layer may be silver or copper. The first electrode layer 23 may be made of ITO. The second electrode layer 21 and the light emitting structure 22 may be an array-distributed structure, and the first electrode layer 23 may be a whole layer covering each light emitting structure 22, or it may be set up to be array-distributed corresponding to each light emitting structure 22. There is no limitation to the specific structure of the first electrode layer 23 in this application. The light emitting unit of this embodiment may comprises light emitting units of multiple colors, for example, a red light emitting unit, a green light emitting unit and a blue light emitting unit, and the light emitting units of different colors are arranged in accordance with a predetermined rule, and there is no restriction on the specific rule for their arrangement in the present application.

Please continue to refer to FIGS. 1 to 3, the light extraction layer assembly 30 is provided on the side of the light emitting device layer 20 facing away from the substrate 10, and the light extraction layer assembly 30 can cover and protect the light emitting device layer 20 from the top; the encapsulation structure 40 is disposed on the side of the light extraction layer assembly 30 facing away from the substrate 10, and the encapsulation structure 40 can cover and protect the light extraction layer assembly 30 and the light emitting device layer 20 from the top.

The light extraction layer assembly 30 and the encapsulation structure 40 may cooperate to adjust the optical interference distance, and suppress external light reflection, thereby enhancing the light extraction efficiency.

The light extraction layer assembly 30 comprises at least two light extraction layers arranged in a stacked configuration, and the at least two light extraction layers comprise a primary extraction layer 31 and a secondary extraction layer 32. The secondary extraction layer 32 comprises at least one secondary extraction layer, the secondary extraction layer 32 is disposed on one side or two opposite sides of the primary extraction layer 31, and the primary extraction layer 31 has a refractive index greater than the secondary extraction layer 32. The at least two light extraction layers can increase the optical interference distance and improve the light extraction efficiency.

In some embodiments, the secondary extraction layer 32 comprises at least one secondary extraction layer, and the secondary extraction layer 32 disposed on one side of the primary extraction layer 31 has a refractive index that gradually decreases in a direction from the primary extraction layer 31 to the secondary extraction layer 32.

Exemplarily, the secondary extraction layer 32 is disposed on only one side of the primary extraction layer 31 facing the substrate 10, the secondary extraction layer 32 comprises a plurality of secondary extraction layers, and the plurality of the secondary extraction layers on the side of the primary extraction layer 31 facing the substrate 10 have refractive indices that gradually decrease in a direction from the primary extraction layer 31 to the secondary extraction layer 32.

Exemplarily, the secondary extraction layer 32 is provided on both the side of the primary extraction layer 31 facing the substrate 10 and the side of the primary extraction layer 31 facing away from the substrate 10. The secondary extraction layer 32 provided on the side of the primary extraction layer 31 facing the substrate 10 comprises a plurality of secondary extraction layers, and the plurality of the secondary extraction layers on the side of the primary extraction layer 31 facing the substrate 10 have refractive indices that gradually decrease in a direction from the primary extraction layer 31 to the secondary extraction layer 32; the secondary extraction layer 32 provided on two opposite sides of the primary extraction layer 31 comprises a plurality of secondary extraction layers, the secondary extraction layer 32 provided on the side of the primary extraction layer 31 facing away from the substrate 10 comprises a plurality of secondary extraction layers, and the plurality of the secondary extraction layers on the side of the primary extraction layer 31 facing away from the substrate 10 have refractive indices that gradually decrease in a direction from the primary extraction layer 31 to the secondary extraction layer 32. Referring to FIG. 1, the arrows point in a direction that includes the primary extraction layer 31 pointing toward the secondary extraction layer 32.

In some embodiments, the secondary extraction layer 32 provided on the side of the primary extraction layer 31 facing the substrate 10 is at least two secondary extraction layers, and the secondary extraction layer 32 provided on the side of the primary extraction layer 31 facing away from the substrate 10 is one secondary extraction layer; alternatively, the secondary extraction layer 32 provided on the side of the primary extraction layer 31 facing the substrate 10 is one secondary extraction layer, and the secondary extraction layer 32 provided on the side of the primary extraction layer 31 facing away from the substrate 10 is at least two secondary extraction layers.

In some embodiments, the light extraction layer assembly 30 is made of an organic material. Exemplarily, the material of the light extraction layer assembly 30 includes a polymer resin such as polyether sulfone (PES), polyarylates (PAR), polyetherimide (PEI), polyethylene naphthalate (PEN), polyethylene terephthalate (PET), polyphenylene sulfide (PPS), polyimide (PI), polycarbonate (PC), triacetylcellulose (TAC), and cellulose acetate propionate (CAP). The light extraction layer assembly 30 can be deposited in a single-chamber vacuum evaporation process, saving one evaporation chamber compared to conventional optical structures. The material of the plurality of secondary extraction layers 32 can be the same or different.

The display panel provided by the embodiments of this application is designed with a light extraction layer assembly 30 and an encapsulation structure 40 above the light emitting device layer 20, and the light extraction layer assembly is designed as a multilayer structure. By coordinating the refractive indices of at least two light extraction layers, the improvement of the light emission effect and efficiency is achieved.

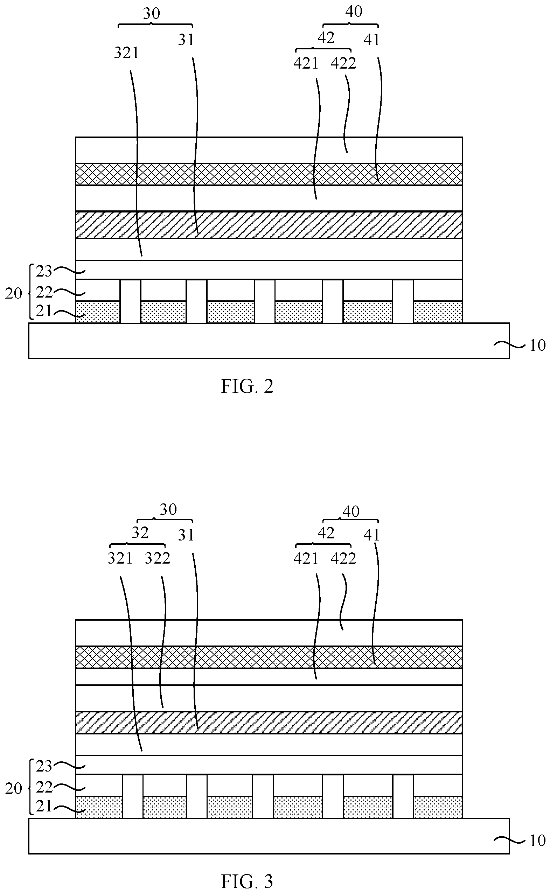

Referring to FIG. 2, in some embodiments, the secondary extraction layer 32 includes at least one first secondary extraction layer 321, which is disposed on the side of the primary extraction layer 31 facing the substrate 10; the encapsulation structure 40 has a refractive index less than the primary extraction layer 31.

According to embodiments of the present application, the first secondary extraction layer 321 has a refractive index less than the primary extraction layer 31, the primary extraction layer 31 has a refractive index greater than the encapsulation structure 40, and a low refractive index structure, a high refractive index structure, a low refractive index structure can be formed over the light emitting device layer 20, forming a microcavity over the light emitting device layer 20. The light emitted from the light emitting device layer 20 is enhanced under the action of the microcavity, which can improve the light extraction efficiency.

In some embodiments, the encapsulation structure 40 is disposed on the surface of the light extraction layer assembly 30, the encapsulation structure 40 protects the light extraction layer assembly 30, and at the same time, the encapsulation structure 40 cooperates with the light extraction layer assembly 30 to improve the light extraction efficiency.

In some embodiments, the primary extraction layer 31 has a refractive index n₂ in a range of 1.7-2.6, i.e., n₂ = 1.7-2.6; and/or, the encapsulation structure 40 has a refractive index in a range of 1.4-2.0, i.e., refractive index = 1.4-2.0.

Exemplarily, the primary extraction layer 31 has a refractive index n₂ of 1.7, 1.8, 1.9, 2.0, 2.1, 2.3, 2.5, or 2.6; the encapsulation structure 40 has a refractive index of 1.4, 1.5, 1.6, 1.7, 1.8, 1.9, or 2.0.

The present application improves the light extraction efficiency by matching the refractive indices of the light extraction layer assembly 30 and the encapsulation structure 40 to form a system that can adjust the light emission direction of the light emitting device layer 20 and/or enhance the light extraction efficiency of the light emitting device layer 20, thereby achieving a better light emission effect.

In some embodiments, the first secondary extraction layer 321 has a refractive index n₁ of 1.2-1.6. Exemplarily, the refractive index n₁ of the first secondary extraction layer 321 is 1.2, 1.3, 1.4, 1.5, or 1.6.

The first secondary extraction layer 321 and the primary extraction layer 31 form a low refractive index and high refractive index arrangement, and most of the light may be refracted into the primary extraction layer 31 at the interface between them, thereby increasing the light extraction efficiency.

In some embodiments, a difference in refractive indexΔn1 (n₂-n₁) between any two light extraction layers of the at least two light extraction layers is greater than 0.5 and less than 1.4. Exemplarily, the value of Δn1 is 0.6, 0.8, 0.9, 1.0, 1.1, 1.2, or 1.3.

The difference in refractive index between any two light extraction layers within the above range allows refractive indices of the light extraction layer assembly to match, thereby improving the light extraction efficiency.

In some embodiments, the primary extraction layer 31 has a thickness greater than the first secondary extraction layer 321; optionally, the thickness diof the first secondary extraction layer 321 is greater than 5 nm and less than 40 nm, and the thickness d₂ of the primary extraction layer 31 is greater than 20 nm and less than 70 nm; optionally, the total thickness Di = d₁ + d₂ of the light extraction layer assembly 30 is greater than 50 nm and less than 110 nm. Exemplarily, the value of d₁ is 8 nm, 10 nm, 15 nm, 20 nm, 25 nm, 30 nm, 35 nm, or 38 nm; the value of d₂ is 25 nm, 30 nm, 35 nm, 40 nm, 45 nm, 50 nm, 55 nm, 60 nm, or 65 nm.

The thickness of each layer of the light extraction layer assembly 30 within the above range ensures that it matches its refractive index to achieve a better light extraction effect.

In some embodiments, the encapsulation structure 40 comprises at least two encapsulation layers arranged in a stacked configuration, including a primary encapsulation layer 41 and at least one secondary encapsulation layer 42, and the at least one secondary encapsulation layer 42 is arranged on one side or two opposite sides of the primary encapsulation layer 41; the primary encapsulation layer 41 has a refractive index less than the secondary encapsulation layer 42.

Two or more encapsulation layers in combination with the light extraction layer assembly 30 can increase the optical interference distance and improve the light extraction efficiency.

In some embodiments, the secondary encapsulation layer 42 includes at least one secondary encapsulation layer, and the secondary encapsulation layer 42 disposed on one side of the primary encapsulation layer 41 has a refractive index that gradually decreases in a direction from the primary encapsulation layer 41 to the secondary encapsulation layer 42.

Exemplarily, the secondary encapsulation layer 42 is disposed on only one side of the primary encapsulation layer 41 facing the substrate 10, the secondary encapsulation layer 42 comprises a plurality of secondary encapsulation layers, and the plurality of the secondary encapsulation layers on the side of the primary encapsulation layer 41 facing the substrate 10 have refractive indices that gradually decrease in a direction from the primary encapsulation layer 41 to the secondary encapsulation layer 42.

Exemplarily, the secondary encapsulation layer 42 is provided on both the side of the primary encapsulation layer 41 facing the substrate 10 and the side of the primary encapsulation layer 41 facing away from the substrate 10. The secondary encapsulation layer 42 provided on the side of the primary encapsulation layer 31 facing the substrate 10 comprises a plurality of secondary extraction layers, and the plurality of the secondary encapsulation layers on the side of the primary encapsulation layer 41 facing the substrate 10 have refractive indices that gradually increase in a direction from the primary encapsulation layer 41 to the secondary encapsulation layer 42; the secondary encapsulation layer 42 provided on the side of the primary encapsulation layer 41 facing away from the substrate 10 comprises a plurality of secondary encapsulation layers, and the plurality of the secondary encapsulation layers on the side of the primary encapsulation layer 41 facing away from the substrate 10 have refractive indices that gradually increase in a direction from the primary encapsulation layer 41 to the secondary encapsulation layer 42. Referring to FIG. 1, the arrows point in a direction that includes the primary encapsulation layer 41 pointing toward the secondary encapsulation layer 42.

In some embodiments, the secondary encapsulation layer 42 provided on the side of the primary encapsulation layer 41 facing the substrate 10 is at least two secondary encapsulation layers, and the secondary encapsulation layer 42 provided on the side of the primary encapsulation layer 41 facing away from the substrate 10 is one secondary extraction layer; alternatively, the secondary encapsulation layer 42 provided on the side of the primary encapsulation layer 41 facing the substrate 10 is one secondary encapsulation layer, and the secondary extraction layer 32 provided on the side of the primary extraction layer 31 facing away from the substrate 10 is at least two secondary encapsulation layers.

In some embodiments, at least one secondary encapsulation layer includes at least one first secondary encapsulation layer 421 and at least one second secondary encapsulation layer 422, and the at least one first secondary encapsulation layer 421 and the at least one second secondary encapsulation layer 422 are disposed on opposite sides of the primary encapsulation layer 41; the first secondary encapsulation layer 421 has a refractive index n₄ in a range of 1.4-2.0, the primary encapsulation layer 41 has a refractive index n₅ in a range of 1.4-1.6, and the second secondary encapsulation layer 422 has a refractive index n₆ in a range of 1.4-2.0.

Exemplarily, n₄ takes a value of 1.4, 1.5, 1.6, 1.7, 1.8, or 1.9; n₅ takes a value of 1.4, 1.5, or 1.6; and n₆ takes a value of 1.4, 1.5, 1.6, 1.7, 1.8, 1.9, or 2.0.

The display panel provided by embodiments of this application is designed with a light extraction layer assembly 30 and an encapsulation structure 40 above the light emitting device layer 20, and the light extraction layer assembly 30 and the encapsulation structure 40 are designed as a multilayer structure. By coordinating the refractive indices of at least two light extraction layers and at least two encapsulation layers, the effect of improving the light extraction effect and efficiency is achieved. Among them, the refractive index of the primary extraction layer 31 is greater than that of the secondary extraction layer 32; the refractive index of the primary encapsulation layer 41 is less than that of the secondary encapsulation layer 42, which may form a structure of low refractive index, high refractive index, low refractive index, and high refractive index above the light emitting device layer 20, forming a microcavity over the light emitting device layer 20. The light emitted from the light emitting device layer 20 is enhanced under the action of the microcavity, thereby improving the light extraction efficiency. The lower refractive index of the secondary extraction layer 32 may reduce energy loss between the light emitting device layer 20 and the light extraction layer assembly 30.

In some embodiments, at least one secondary encapsulation layer is disposed on two opposite sides of the primary encapsulation layer, and the refractive indices of the secondary encapsulation layers on the two opposite sides of the primary encapsulation layer are the same. For example, the first secondary encapsulation layer 421 has a refractive index of 1.5, the primary encapsulation layer 41 has a refractive index of 1.4, and the second secondary encapsulation layer 422 may have a refractive index of 1.5. When the refractive index of the first secondary encapsulation layer 421 is the same as that of the second secondary encapsulation layer 422, it can reduce light loss at the interface and improve the light extraction efficiency.

The refractive indices of the first secondary encapsulation layer 421 and the second secondary encapsulation layer 422 may also be different. For example, the refractive index of the first secondary encapsulation layer 421 is 1.5, the refractive index of the primary encapsulation layer 41 is 1.4, and the refractive index of the second secondary encapsulation layer 422 may be 1.6.

The material of the secondary encapsulation layer may be an inorganic material. The first secondary encapsulation layer 421 and the second secondary encapsulation layer 422 may comprise one or more inorganic insulating materials selected from a group consisting of aluminum oxide, titanium oxide, tantalum oxide, hafnium oxide, zinc oxide, silicon oxide, silicon nitride, and silicon oxynitride.

In some embodiments, the first secondary encapsulation layer 421 and the second secondary encapsulation layer 422 may include an inorganic insulating layer containing non-metallic elements such as silicon oxide, silicon nitride, or silicon oxynitride. The material of the first secondary encapsulation layer 421 and the second secondary encapsulation layer 422 may be the same or different. For example, the first secondary encapsulation layer 421 may comprise silicon oxynitride, and the second secondary encapsulation layer 422 may comprise silicon nitride, without being limited to thereto.

The material of the primary encapsulation layer 41 may be an organic material, which can alleviate internal stress of the first secondary encapsulation layer 421 and/or the second secondary encapsulation layer 422. The material of the primary encapsulation layer 41 may include a polymer-based material. The polymer-based materials may include polyethylene terephthalate, polyethylene naphthalate, polycarbonate, polyimide, polyvinyl sulfate, polyformaldehyde, polyarylate, hexamethyldisiloxane, and acrylic resin (e.g., polymethyl methacrylate or polyacrylic acid, etc.) or any combination thereof.

In some embodiments, when a difference in refractive index Δn2 (n₄-n₅ or n₆-ns) between any two encapsulation layers among the at least two encapsulation layers is less than 0.2, a difference in refractive index△n3 (n₂-n₁) of the light extraction layers is greater than 0.6 and less than 1.2, optionally, n₂=2.2-2.6.

Exemplarily, △n3 takes a value of 0.7, 0.8, 0.9, 1.0, or 1.1; and n₂ takes a value of 2.2, 2.3, 2.4, 2.5, or 2.6.

When the difference in refractive index of the encapsulation layers is small, it is necessary to require a relatively small difference in refractive index of the light extraction layers to achieve refractive index matching.

In some embodiments, n₁ = 1.4-1 .6, n₂ = 2.0 -2.4, n₄ = 1.7-2.0, n₅ = 1.4-1.6, n₆ = 1.7-2.0, and a difference in refractive index △n4 (n₂-n₄) between the primary extraction layer 31 and the first secondary encapsulation layer 421 is greater than or equal to 0 and less than 0.5. Exemplarily, the value of △n4 is 0.1, 0.2, 0.3, or 0.4.

The light extraction layer assembly 30 and the encapsulation layer assembly 40 form an alternating arrangement of low/high/low/high refractive index, and a difference in refractive index between the primary extraction layer 31 and the first secondary encapsulation layer 421 is small, which can further increase the light extraction efficiency.

Referring to Figure 3, in some embodiments, the secondary extraction layer 32 includes at least one first secondary extraction layer 321, which is disposed on one side of the primary extraction layer facing the substrate 10; the secondary extraction layer 32 further includes at least one second secondary extraction layer 322; the at least one second secondary extraction layer 322 is disposed on the side of the primary extraction layer 31 facing away from the substrate 10, and the refractive index of the second secondary extraction layer 322 is less than that of the encapsulation structure.

The light extraction layer assembly 30 includes a first secondary extraction layer 321, a primary extraction layer 31, and a second secondary extraction layer 322 from bottom to top. The refractive index of the primary extraction layer 31 is greater than that of the first secondary extraction layer 321, and the refractive index of the primary extraction layer 31 is greater than that of the second secondary extraction layer 322, forming a low refractive index, high refractive index, low refractive index system in the light extraction layer assembly 30.

A microcavity is formed among the light extraction layer assembly 30, the encapsulation structure 40, and the light emitting device layer 20, and the light emitted from the light emitting device layer 20 is enhanced under the action of the microcavity, thereby improving the light extraction efficiency.

The material of the first secondary extraction layer 321 and the second secondary extraction layer 322 may be the same or different. In some embodiments, the material of the light extraction layer assembly 30 is an organic material, which can reduce the stress between the layers and enhance the formability of the panel, for example, it can be rolled up or folded. Exemplarily, the material of the light extraction layer assembly 30 includes a polymer resin such as polyether sulfone (PES), polyarylates (PAR), polyetherimide (PEI), polyethylene naphthalate (PEN), polyethylene terephthalate (PET), polyphenylene sulfide (PPS), polyimide (PI), polycarbonate (PC), triacetylcellulose (TAC), and cellulose acetate propionate (CAP). The light extraction layer assembly 30 may be deposited in a single-chamber vacuum evaporation process, saving one evaporation chamber compared to conventional optical structures.

In some embodiments, the first secondary extraction layer 321 has a refractive index n₁ in a range of 1.2-1.6; the primary extraction layer 31 has a refractive index n₂ in a range of 1.7-2.6; and the second secondary extraction layer 322 has a refractive index n₃ in a range of 1.2-1.6.

Exemplarily, n₁ takes a value of 1.2, 1.3, 1.4, 1.5, or 1.6; n₂ takes a value of 1.7, 1.8, 1.9, 2.0, 2.1, 2.3, 2.5, or 2.6; and n₃ takes a value of 1.2, 1.3, 1.4, 1.5, or 1.6.

The refractive index of each layer of the light extraction layer assembly is within the above ranges, ensuring that each layer cooperates with each other to achieve better light extraction effects.

In some embodiments, the encapsulation structure 40 comprises at least two encapsulation layers arranged in a stacked configuration, including a primary encapsulation layer 41 and at least one secondary encapsulation layer, and the at least one secondary encapsulation layer comprises at least one first secondary encapsulation layer and at least one second secondary encapsulation layer. The at least one first secondary encapsulation layer and the at least one second secondary encapsulation layer are disposed on two opposite sides of the primary encapsulation layer 41; the primary encapsulation layer 41 has a refractive index less than the secondary encapsulation layer 42; and the second secondary extraction layer 322 has a refractive index less than the first secondary encapsulation layer 421.

The encapsulation structure 40 includes a first secondary encapsulation layer 421, a primary encapsulation layer 41, and a second secondary encapsulation layer 422 from bottom to top. The refractive index of the primary encapsulation layer 41 is less than that of the first secondary encapsulation layer 421, the refractive index of the primary encapsulation layer 41 is less than that of the second secondary encapsulation layer 422, and the refractive index of the second secondary extraction layer 322 is less than that of the first secondary encapsulation layer 421. A low refractive index, high refractive index, low refractive index, and high refractive index system is formed from the encapsulation structure 40 and the second secondary extraction layer 322.

A microcavity is formed among the light extraction layer assembly 30, the encapsulation structure 40, and the light emitting device layer 20, and the light emitted from the light emitting device layer 20 is enhanced under the action of the microcavity, thereby improving the light extraction efficiency.

In some embodiments, the first secondary encapsulation layer 421 has a refractive index n₄ in a range of 1.4-2.0, the primary encapsulation layer 41 has a refractive index n₅ in a range of 1.4-1.6, and the second secondary encapsulation layer 422 has a refractive index n₆ in a range of 1.4-2.0.

Exemplarily, n₄ takes a value of 1.4, 1.5, 1.6, 1.7, 1.8, or 1.9; n₅ takes a value of 1.4, 1.5, or 1.6; and n₆ takes a value of 1.4, 1.5, 1.6, 1.7, 1.8, 1.9, or 2.0.

A low refractive index, high refractive index, low refractive index, high refractive index system is formed from the second secondary extraction layer 322 together with the first secondary encapsulation layer 421, the primary encapsulation layer 41, and the second secondary encapsulation layer 422, which can improve the light extraction efficiency.

In some embodiments, the thickness of the first secondary extraction layer 321 is in a range of 0 < d₁ < 40nm, the thickness of the primary extraction layer 31 is in a range of 30nm < d₂ < 70nm, and the thickness of the second secondary extraction layer 322 is in a range of 20nm < d₃ < 50nm.

Exemplarily, d1 takes a value of 8 nm, 10 nm, 15nm, 20nm, 25 nm, 30 nm, 35 nm, or 38 nm; d2 takes a value of 25 nm, 30 nm, 35nm, 40nm, 45 nm, 50 nm, 55 nm, 60 nm, or 65 nm; and d3 takes a value of 25 nm, 28nm, 30nm, 35 nm, 38 nm, 40nm, 42nm, 45 nm, or 48nm.

In some embodiments, a total thickness D₂ = d₁ + d₂ + d₃ of the light extraction layer assembly 30 is greater than 70nm and less than 160nm, and a difference in refractive index △n5 (n₂-n₁ or n₂-n₃) is greater than 0.5 and less than 1.4. Exemplarily, Δn5 takes a value of 0.7, 0.8, 0.9, 1.0, 1.2, or 1.3.

The thickness of each layer of the light extraction layer assembly within the above ranges ensures that it matches its refractive index to achieve a better light extraction effects. The embodiments of this application improve the light extraction efficiency by adjusting the refractive index and thickness of the light extraction layer assembly 30 and the encapsulation structure 40.

In some embodiments, the thickness of the first secondary encapsulation layer d₄ is in a range of 1-1.5um, the thickness of the primary encapsulation layer d₅ is in a range of 9-12um, and the thickness of the second secondary encapsulation layer d₆ is in a range of 0.7-1.2um.

Exemplarily, d₄ takes a value of 1.0um, 1.1um, 1.2um, 1.3um, 1.4um, or 1.5um; d₅ takes a value of 9um, 10um, 11um, or 12um; and d₆ takes a value of 0.7um, 0.8um, 0.9um, 1.0um, 1.1um, or 1.2um.

In some embodiments, n₃ = 1.4-1.6, n₄ = 1.8-2.0, n₅ = 1.4-1.6, and n₆ = 1.8-2.0.

In some embodiments, when a difference in refractive index △n6 (n₄-n₅ or n₆-n₅) between any two encapsulation layers among the at least two encapsulation layers is less than 0.4, a difference in refractive index △n7 (n₄-n₃) between the first secondary encapsulation layer 421 and the second secondary extraction layer 322 is greater than or equal to 0 and less than 0.5. Exemplarily, the value of △n7 is 0.1, 0.2, 0.3, or 0.4.

When a difference in refractive index of the encapsulation layers is small, it is necessary to require a relatively small difference in refractive index between the first secondary encapsulation layer 421 and the second secondary extraction layer 322 to achieve refractive index matching, which can further improve the light extraction efficiency.

In some embodiments, referring to FIG. 4, the light emitting device layer 20 includes a plurality of light emitting units, and the orthographic projection of each unit on the substrate is located within the orthographic projection of the light extraction layer assembly on the substrate.

The orthographic projection of the light extraction layer assembly on the substrate covers the orthographic projection of each light emitting unit on the substrate; preferably, the orthographic projection of the light extraction layer assembly on the substrate coincides with the orthographic projection of each light emitting unit on the substrate. This ensures that the light extraction layer assembly 40 is provided directly above each light emitting unit.

In some embodiments, referring to FIG. 5, the light emitting device layer comprises a first color light emitting unit 20a and a second color light emitting unit 20b, the first color light emitting unit 20a having a orthographic projection on the substrate 10 within the orthographic projection of the light extraction layer assembly 30 on the substrate 10, the second color light emitting unit 20b having a orthographic projection on the substrate 10 outside the orthographic projection of the light extraction layer assembly 30 on the substrate 10. Optionally, the first color is blue and the second color is red or green. The present application does not limit thereto.

In a second aspect, embodiments of the present application provide a display module comprising a display panel as described above.

Since the display module according to the embodiments of the present application includes the display panel of any of the above embodiments, the beneficial effects of the display panel of the above embodiments are available and will not be repeated herein. Among other things, the display module according to the embodiments of the present application may include a structure such as a polarizer, a touch control layer, and a cover plate. The polarizer is disposed between the touch control layer and the display panel, and the cover plate is disposed on a side of the touch control layer facing away from the display panel.

In a third aspect, embodiments of the present application provide a display device including the above-mentioned display panel or the above-mentioned display module.

The display device according to the embodiments of the present application includes, but is not limited to, a mobile phone, a Personal Digital Assistant (PDA), a tablet computer, an e-book, a television, a doorstop, a smart landline phone, a console, and other devices with display functions.

Since the display device according to the embodiments of the present application includes a display module or a display panel of any of the above-described embodiments, the beneficial effects of the display panel of the above embodiments are available and will not be repeated herein.

The following examples describe the disclosure of the present application more specifically, and these examples are used for expository illustration only, as various modifications and changes within the scope of the present application will be apparent to those skilled in the art.

### Example 1

The display panel included: a substrate, a light emitting device layer, a light extraction layer assembly, and an encapsulation layer assembly, which are provided in a stacked arrangement.

The light emitting device layer included a second electrode layer, a light emitting structure, and a first electrode layer from bottom to top, wherein the light emitting structure had a refractive index of 1.9.

The light extraction layer assembly included a first secondary extraction layer, a primary extraction layer, and a second secondary extraction layer from bottom to top, all of which were made of an organic material, wherein the first secondary extraction layer had a refractive index n of 1.5 and a thickness d of 20 nm, the primary extraction layer had a refractive index n of 2.2 and a thickness d of 50 nm, and the second secondary extraction layer had a refractive index n of 1.5 and a thickness d of 25 nm.

The encapsulation layer assembly included, from bottom to top, a first secondary encapsulation layer, a primary encapsulation layer, and a second secondary encapsulation layer, wherein the first secondary encapsulation layer had of refractive index of n=1.8, and a thickness of d=1.2um; the primary encapsulation layer had a refractive index of n=1.6, and a thickness of d=11um; the second secondary encapsulation layer had a refractive index of n=1.8, and a thickness of d=1.0um; the overall encapsulation structure and optical structure refractive index satisfy an alternating low-high-low-high-low-high arrangement.

### Example 2

A display panel was similar in structure to the display panel of Example 1, with the exception in that:
The light extraction layer assembly included a first secondary extraction layer, a primary extraction layer, and a second secondary extraction layer from bottom to top, all of which were made of an organic material, wherein the first secondary extraction layer had a refractive index n of 1.6 and a thickness d of 25 nm, the primary extraction layer had a refractive index n of 2.3 and a thickness d of 45 nm, and the second secondary extraction layer had a refractive index n of 1.4 and a thickness d of 25 nm.

The first secondary encapsulation layer had a refractive index of n=1.6, and a thickness of d=1.0um; the primary encapsulation layer had a refractive index of n=1.4, and a thickness of d=9.5um; the second secondary encapsulation layer had a refractive index of n=1.7, and a thickness of d=0.7-1.0um. The difference in refractive index between the encapsulation layers was less than 0.4, and at the same time, the difference in refractive index between the encapsulation structure and the second secondary extraction layer was within 0.5. The overall encapsulation structure and optical structure refractive index satisfy a low-high-low arrangement.

### Example 3

A display panel was similar in structure to the display panel of Example 1, with the exception in that: the light extraction layer assembly included a first secondary extraction layer, and a primary extraction layer, from bottom to top, wherein the first secondary extraction layer had a refractive index n of 1.6 and a thickness d of 25 nm, and the primary extraction layer had a refractive index n of 2.0 and a thickness d of 45 nm.

The encapsulation layer assembly included, from bottom to top, a first secondary encapsulation layer, a primary encapsulation layer, and a second secondary encapsulation layer, wherein the first secondary encapsulation layer had a refractive index of n=1.8, and a thickness of d=1.1um; the primary encapsulation layer had a refractive index of n=1.4, and a thickness of d=9.5um; the second secondary encapsulation layer had a refractive index of n=1.9, and a thickness of d=1.0um; the difference in refractive index between the primary extraction layer and the first secondary encapsulation layer was within 0.5 and the overall encapsulation structure and optical structure refractive index satisfy an alternating low-high-low-high arrangement.

### Example 4

A display panel was similar in structure to the display panel of Example 3, with the exception in that:
The light extraction layer assembly included a first secondary extraction layer, and a primary extraction layer, from bottom to top, wherein the first secondary extraction layer had a refractive index n of 1.5 and a thickness d of 30 nm, and the primary extraction layer had a refractive index n of 2.1 and a thickness d of 60 nm.

The first secondary encapsulation layer had a refractive index of n=1.5, and a thickness of d=1.0um; the primary encapsulation layer had a refractive index of n=1.3, and a thickness of d=10um; the second secondary encapsulation layer had a refractive index of n=1.5, and a thickness of d=1.2um. The overall encapsulation structure and optical structure refractive index satisfy an alternating low-high-low arrangement.

### Comparative Example 1

A display panel was similar in structure to the display panel of Example 1, with the exception in that the light extraction layer assembly included, from bottom to top, an organic light extraction layer and a LiF layer, wherein the organic light extraction layer had a refractive index of n=2.1, and a thickness of d=75nm; and the LiF layer had a refractive index of n=1.4, and a thickness of d=30nm.

**Table 1: White Light Efficiency of Examples 1-4 and Comparative Example 1**

| Scheme | Light extraction layer assembly | LiF | Encapsulation structure | White Light Efficiency |
|---|---|---|---|---|
| Example 1 | Low-High-Low Three Layers | No | High-low-high | 107% |
| Example 2 | Low-High-Low Three Layers | No | high-low-high | 110% |
| Example 3 | Low-High Two Layers | No | high-low-high | 104% |
| Example 4 | Low-High Two Layers | No | high-low-high | 105% |
| Comparative Example 1 | Single high layer | Yes | high-low-high | 100% |

As can be seen from Table 1, the examples 1-4 of the present application, achieved an increase in light extraction efficiency and a better light extraction effect by matching the light extraction layer assembly with the encapsulation layer assembly in terms of refractive index and thickness to form a system that can adjust the light extraction direction of the light emitting device layer and/or enhance the light extraction efficiency of the light emitting device layer. Among them, the refractive index of the primary extraction layer was greater than that of the first secondary extraction layer, and the refractive index of the primary extraction layer was greater than that of the encapsulation structure. The light extraction layer assembly and the encapsulation structure formed a low refractive index, high refractive index, low refractive index system, and a microcavity was formed over the light emitting device layer. The light emitted from the light emitting device layer was enhanced under the action of the microcavity, thereby improving the light extraction efficiency. Compared to Comparative Example 1, the present application improved the light extraction efficiency by optimizing the structure.

While the application has been described with reference to the preferred embodiments, various modifications may be made and equivalents may be substituted for parts thereof without departing from the scope of the application. In particular, as long as there is no structural conflict, each technical feature mentioned in each embodiment can be combined in any manner. The present application is not limited to the specific embodiments disclosed herein, but includes all technical solutions falling within the scope of the claims.

## Claims

1. A display panel, comprising a substrate (10) and a light emitting device layer (20) disposed on one side of the substrate (10), **characterized in that** the display panel further comprises:
a light extraction layer assembly (30) disposed on a side of the light emitting device layer (20) facing away from the substrate (10), wherein the light extraction layer assembly (30) comprises at least two light extraction layers arranged in a stacked configuration, the at least two light extraction layers comprise a primary extraction layer (31) and at least one secondary extraction layer (32) disposed on one side or two opposite sides of the primary extraction layer (31), and a refractive index n₂ of the primary extraction layer (31) is greater than a refractive index of the secondary extraction layer (32); and
an encapsulation structure (40) disposed on a side of the light extraction layer assembly (30) facing away from the substrate (10).

2. The display panel as claimed in claim 1, wherein the secondary extraction layer (32) comprises at least a first secondary extraction layer (321), the first secondary extraction layer (321) is disposed on a side of the primary extraction layer (31) facing the substrate (10); and a refractive index of the encapsulation structure (40) is less than the refractive index n₂ of the primary extraction layer (31).

3. The display panel as claimed in claim 2, wherein
the refractive index n₂ of the primary extraction layer (31) is in a range of 1 .7-2.6;
the refractive index of the encapsulation structure (40) is in a range of 1.4-2.0; and
a refractive index n₁ of the first secondary extraction layer (321) is in a range of 1.2-1.6.

4. The display panel as claimed in claim 2, wherein
a thickness d₂ of the primary extraction layer (31) is greater than a thickness d₁ of the first secondary extraction layer (321);
the thickness d₁ of the first secondary extraction layer (321) is greater than 5 nm and less than 40 nm;
the thickness d₂ of the primary extraction layer (31) is greater than 20 nm and less than 70nm; and
a total thickness D₁=d₁+d₂ of the light extraction layer assembly (30) is greater than 50nm and less than 110nm.

5. The display panel as claimed in claim 2, wherein that the encapsulation structure (40) comprises at least two encapsulation layers arranged in a stacked configuration, the at least two encapsulation layers comprise a primary encapsulation layer (41) and at least one secondary encapsulation layer (42), the at least one secondary encapsulation layer (42) is disposed on one side or two opposite sides of the primary encapsulation layer (41); and a refractive index n₅ of the primary encapsulation layer (41) is less than a refractive index of the secondary encapsulation layer (42).

6. The display panel as claimed in claim 5, wherein the at least one secondary encapsulation layer (42) comprises at least one first secondary encapsulation layer (421) and at least one second secondary encapsulation layer (422), and the at least one first secondary encapsulation layer (421) and the at least one second secondary encapsulation layer (422) are disposed on two opposite sides of the primary encapsulation layer (41), respectively; and a refractive index n₄ of the first secondary encapsulation layer (421) is in a range of 1.4-2.0, the refractive index n₅ of the primary encapsulation layer (41) is in a range of 1.4-1.6, and a refractive index n₆ of the second secondary encapsulation layer (422) is in a range of 1.4-2.0.

7. The display panel as claimed in claim 5, wherein
the at least one secondary encapsulation layer (42) comprises a plurality of secondary encapsulation layers disposed on the one side of the primary encapsulation layer (41), and refractive indices of the plurality of secondary encapsulation layers sequentially increase in a direction from the primary encapsulation layer (41) to the secondary encapsulation layer (42).

8. The display panel as claimed in claim 6, wherein when a difference in refractive index Δn2 (n₄-n₅ or n₆-n₅) between any two encapsulation layers of the at least two encapsulation layers is less than 0.2, a difference in refractive index Δn3 (n₂-n₄) between the primary extraction layer (31) and the first secondary encapsulation layer (321) is greater than 0.6 and less than 1.2.

9. The display panel as claimed in claim 6, wherein a refractive index n₁ of the first secondary extraction layer (321) is less than a refractive index n₄ of the first secondary encapsulation layer (421),
the refractive index n₁ of the first secondary extraction layer (321) is in a range of 1.4-1.6, the refractive index n₂ of the primary extraction layer (31) is in a range of 2.0 -2.4, the refractive index n₄ of the first secondary encapsulation layer (421) is in a range of 1.7-2.0, the refractive index n₆ of the second secondary encapsulation layer (422) is in a range of 1.7-2.0, and a difference in refractive index Δn4 (n₂-n₄) between the primary extraction layer (41) and the first secondary encapsulation layer (421) is equal to or greater than 0 and less than 0.5.

10. The display panel as claimed in claim 1, wherein the secondary extraction layer (32) comprises at least one first secondary extraction layer (321) disposed on a side of the primary extraction layer (31) facing the substrate (10); the secondary extraction layer (32) further comprises at least one second secondary extraction layer (322) disposed on a side of the primary extraction layer (31) facing away from the substrate (10); a refractive index n₃ of the second secondary extraction layer (322) is less than a refractive index of the encapsulation structure (40).

11. The display panel as claimed in claim 10, wherein a refractive index n₁ of the first secondary extraction layer (321) is in a range of 1.2-1.6; the refractive index n₂ of the primary extraction layer (31) is in a range of 1.7-2.6; a refractive index n₃ of the second secondary extraction layer (322) is in a range of 1.2-1.6.

12. The display panel as claimed in claim 10 or 11, wherein the encapsulation structure (40) comprises at least two encapsulation layers arranged in a stacked configuration, the at least two encapsulation layers comprise a primary encapsulation layer (41) and at least one secondary encapsulation layer (42), the at least one secondary encapsulation layer (42) comprises at least one first secondary encapsulation layer (421) and at least one second secondary encapsulation layer (422), the at least one first secondary encapsulation layer (421) and the at least one second secondary encapsulation layer (422) are disposed on two opposite sides of the primary encapsulation layer (41), respectively; a refractive index n₅ of the primary encapsulation layer (41) is less than a refractive index n₄ of the secondary encapsulation layer (42) and less than a refractive index n₆ of the second secondary encapsulation layer (422); and the refractive index n₃ of the second secondary extraction layer (422) is less than the refractive index n₄ of the first secondary encapsulation layer (421),
the refractive index n₄ of the first secondary encapsulation layer (421) is in a range of 1.4-2.0, the refractive index n₅ of the primary encapsulation layer (41) is in a range of 1.4-1.6, a refractive index n₆ of the second secondary encapsulation layer (422) is in a range of 1.4-2.0.

13. The display panel as claimed in claim 10, wherein the first secondary extraction layer (321) has a thickness d₁ greater than 0 and less than 40nm, the primary extraction layer (31) has a thickness d₂ greater than 30nm and less than 70nm, the second secondary extraction layer (322) has a thickness d₃ greater than 20nm and less than 50nm; and a total thickness D₂=d₁+d₂+d₃ of the light extraction layer assembly (30) is greater than 70nm and less than 160nm.

14. The display panel as claimed in claim 12, wherein when a difference in refractive index Δn6(n₄-n₅ or n₆-n₅) between any two encapsulation layers of the at least two encapsulation layers is less than 0.4, a difference in refractive index Δn7(n4-n3) between the first secondary encapsulation layer (421) and the second secondary extraction layer (422) is greater than or equal to 0 and less than 0.5.

15. The display panel as claimed in claim 1, wherein the light emitting device layer (20) comprises a plurality of light emitting units, each of the plurality of the light emitting units has an orthographic projection on the substrate (10) located within an orthographic projection of the light extraction layer assembly (30) on the substrate (10); or
the light emitting device layer (20) comprises a light emitting unit of a first color (20a) and a light emitting unit of a second color (20b), the light emitting unit of the first color (20a) has an orthographic projection on the substrate (10) located within the orthographic projection of the light extraction layer assembly (30) on the substrate (10), and the light emitting unit of the second color (20b) has an orthographic projection on the substrate (10) located outside the orthographic projection of the light extraction layer assembly (30) on the substrate (10); and
the first color is blue and the second color is red or green.
